# EUROPEAN PATENT SPECIFICATION

(11) **EP 1 633 678 B1**
(45) Date of publication and mention of the grant of the patent: **17.05.2017**
(21) Application number: 04736701.6
(22) Date of filing: 11.06.2004
(51) Int. Cl.: C01F 7/00

(54) **METHOD FOR PRODUCING PARTICULATE ALUMINA AND COMPOSITION CONTAINING PARTICULATE ALUMINA**
VERFAHREN ZUR HERSTELLUNG VON TEILCHENFÖRMIGEN ALUMINIUMOXID UND DIESES ALUMINIUMOXID ENTHALTENDE
PROCEDE DE PRODUCTION D'ALUMINE PARTICULAIRE ET COMPOSITION CONTENANT DE L'ALUMINE PARTICULAIRE

(30) Priority: 12.06.2003 JP 2003167778
(43) Date of publication of application: 15.03.2006
(73) Proprietor: Showa Denko K.K., Tokyo 105-8518 (JP)
(72) Inventor: KAMIMURA, Katsuhiko, Showa Denko K.K. Yokohama Pl., Yokohama-shi, Kanagawa 221-0024 (JP); YAMADA, Tomiharu, Showa Denko K.K. Yokohama Plant, Yokohama-shi, Kanagawa 221 -0024 (JP)
(74) Representative: Strehl Schübel-Hopf & Partner
(86) International application number: PCT/JP2004/008546
(87) International publication number: WO 2004/110931

(56) References cited:
- EP-A- 0 265 839
- EP-A- 0 276 321
- WO-A-02/34692
- WO-A-90/15777
- WO-A-02/098796
- DE-A- 1 767 511
- US-A- 3 092 453
- US-A- 3 262 754
- DATABASE WPI Section Ch, Week 200323 Derwent Publications Ltd., London, GB; Class E33, AN 1995-118570 XP002337702 & JP 03 389642 B2 (NIPPON LIGHT METAL CO) 24 March 2003 (2003-03-24)

## Description

### TECHNICAL FIELD

The present invention relates to a method for producing a rounded (roundedly shaped) particulate alumina, more specifically, the present invention relates to a production method of a particulate alumina which is useful, for example, as a sealing material of electronic components, a filler, a finish lapping material or an aggregate of refractories, glasses, ceramics or their composite materials, and also relates to a resin composition and the like using the particulate alumina.

### BACKGROUND ART

To cope with recent trend toward the realization of advanced information telecommunication represented by multimedia, the electronic components used for these devices are required to respond to high-speed/high-frequency processing or modularization and a matter of importance in the development is, for example, to improve the electrical properties, such as reduction of dielectric constant. Furthermore, with the progress of high-integration and high-density packaging of electronic components, the power consumption per chip is more and more increasing and it is also a matter of importance in the development to efficiently dissipate the heat generated and less elevate the temperature of the electronic component device. Under these circumstances, alumina having excellent thermal conductivity, particularly corundum (α-alumina), is attracting attention as a filler for use in an insulating sealing material of semiconductors, a substrate material on which the components are mounted, or a heat-radiating spacer, and being used in various fields.

As such a corundum particle, a spherically shaped corundum particle having no cutting edge and having an average particle size of 5 to 35 µm has been proposed, which is obtained by adding aluminum hydroxide alone or in combination with another known chemical as the crystallization accelerator to a ground product of electrofused alumina or sintered alumina, and calcining it (see, for example, JP-A-5-294613 (the term "JP-A" as used herein means an "unexamined published Japanese patent application")).

In this patent publication, it is stated that in the case of a corundum particle having an average particle size of 5 µm or less, a particle having a rounded shape can be obtained by a known method of adding a crystallization accelerating agent to aluminum hydroxide.

Also, a technique of thoroughly dehydrating and thermally decomposing alumina hydroxide at 700°C or less at the calcining, then elevating the temperature to produce an intermediate calcined material having an α-conversion of 90% or more, and calcining it in the presence of a fluorine hardening agent to obtain spherical alumina has been disclosed (see, for example, JP-A-5-43224).

On the other hand, there is known a so-called flame-spraying method where alumina according to the Bayer process is jetted into a high-temperature plasma or oxyhydrogen flame and the alumina under melting is rapidly cooled, thereby forming a rounded crystal particle. In some situations, this method might be unprofitable due to large unit heat consumption, the obtained alumina might contain δ-alumina as a by-product.

As for the corundum particle, ground products of electrofused alumina or sintered alumina are known, but these are both an amorphously shaped particle having sharp cutting edges and their filling in rubbers or plastics might cause great abrasion of the kneader, shaping die or the like.

WO-A-02098796 discloses a resin composition comprising roundish alumina particles, and a method for producing a particulate alumina comprising heat-treating a composition comprising alumina and at least one species selected from the group consisting of a halogen compound, a boron compound and an alumina hydrate and then disintegrating the heat-treated product.

### DISCLOSURE OF THE INVENTION

An object of the present invention is to produce a rounded particulate α-alumina having excellent flowability for use as a filler, for example, in resin such as rubber and plastic or in glass and provide a highly thermally conductive rubber composition, a highly thermally conductive plastic composition and a ceramic composition each using the particulate α-alumina.

As a result of intensive investigations to develop a particulate α-alumina having the above-described preferred properties, the present inventors have found that when a specific composition is baked and disintegrated, a rounded particulate α-alumina having excellent flowability and low viscosity can be obtained and this ensures good filling in rubbers, plastics or ceramics. The present invention has been accomplished based on this finding.

That is, the present invention relates to a method for producing particulate α-alumina and to a composition containing particulate alumina as follows.
[1] A method for producing a particulate α-alumina having an average particle size of 10 µm or less, comprising heat-treating (calcining) a composition comprising alumina having an average particle size of 0.3 to 8 µm, an alumina hydrate having an average particle size of 10 µm or less in an amount of 5 to 300 mass% in terms of alumina, ammonium chloride in an amount of 2 to 8 mass% based on the entire alumina content, a fluorine compound or a boron-fluorine compound, and a boron compound in an amount of 1 to 7 mass% based on the entire alumina content at a heating temperature of 1,000°C or higher and 1,600°C or lower, and then disintegrating the heat-treated product.
[2] The production method of a particulate alumina as claimed in [1], wherein the fluorine compound is at least one member selected from the group consisting of AlF₃, NaF, CaF₂, MgF₂ and Na₃AlF₆.
[3] The production method of a particulate alumina as claimed in [1], wherein the boron compound is at least one member selected from the group consisting of B₂O₃, H₃BO₃, mNA₂O ·nB₂O₃ (m and n each represents an integer of 1 or more, hereinafter the same) and a boron-fluorine compound.
[4] The production method of a particulate alumina as claimed in any of [1] to [3], wherein the particulate alumina has a rounded shape having no cutting edge.
[5] The production method of a particulate alumina as claimed in any one of [1] to [4], wherein the composition is previously granulated before heat-treating (calcining) the composition.
[6] The production method of a particulate alumina as claimed in any one of [1] to [5], wherein the alumina hydrate is at least one member selected from the group consisting of an aluminum hydroxide, an alumina gel and a partially hydrated aluminum compound.
[7] A resin composition comprising a particulate alumina produced by the production method as claimed in any one of [1] to [6], and a polymer compound.
[8] The resin composition as claimed in [7], wherein the polymer compound is at least one member selected from an aliphatic resin, an unsaturated polyester resin, an acrylic resin, a methacrylic resin, a vinyl ester resin, an epoxy resin and a silicone resin.
[9] The resin composition as claimed in [7] or [8], wherein the content of the particulate alumina is 70 mass% or more.
[10] The resin composition as claimed in any one of [7] to [9], wherein the particulate alumina is coated with a surface-treating agent.
[11] The resin composition as claimed in [10], wherein the surface-treating agent is a silane coupling agent.
[12] The resin composition as claimed in [10], wherein the surface-treating agent is a compound having one or more group selected from the group consisting of an amino group, a carboxyl group and an epoxy group.
[13] The resin composition as claimed in [10], wherein the surface-treating agent is a modified silicone oil.
[14] The resin composition as claimed in any one of [10] to [13], wherein the coverage of the surface-treating agent is from 0.05 to 5 mass% based on the particulate alumina.
[15] A ceramic composition comprising a particulate alumina produced by the production method as claimed in any one of [1] to [6].
[16] An electronic component or semiconductor device comprising the resin composition as claimed in any one of [7] to [14].
[17] A central processing unit (CPU) or plasma display (PDP) comprising the resin composition as claimed in any one of [7] to [14].
[18] A peripheral equipment for batteries, or a peltier element, an inverter or a power transistor, comprising the resin composition as claimed in any one of [7] to [14].

### DETAILED DESCRIPTION OF INVENTION

The present invention is described in detail below.

The alumina used as a starting material in the present invention is a ground product of a calcined alumina produced by a known production method, and the particle size is, in terms of the average particle size, within a range of 0.3 to 8 µm, preferably 1 to 7 µm.

In order to accelerate the rounding of starting material alumina, an alumina hydrate (rounding accelerator) is previously mixed with alumina before heat treatment.

The alumina hydrate used here may be, for example, an aluminum hydroxide such as gibbsite, bayerite, boehmite and diaspore, an amorphous aluminum hydroxide such as alumina gel and pseudo-boehmite, or a partially hydrated aluminum compound such as aluminum oxide (alumina) of which surface is partially hydrated, but in particular, the alumina hydrate is preferably an aluminum hydroxide, an alumina gel or a fine particulate alumina having good thermal reactivity.

From the economic point of view, an aluminum hydroxide according to the Bayer process (gibbsite) is preferred and its average particle size is 10 µm or less, preferably 5 µm or less.

The present inventors have confirmed by observation that this rounding accelerator acts on alumina synergistically with the other chemicals (additives) described later to selectively react with irregular cutting edges and thereby round the alumina and at the same time, the agglomerate as the heat-treated product is low in the cohesive force and can be easily disintegrated into primary particles.

The optimal amount of the rounding accelerator added varies depending on the particle size of the ground product of alumina, but in the case of adding an aluminum hydroxide, the amount added is, in terms of alumina, from 5 to 300 mass%, preferably from 80 to 180 mass%, based on alumina. If the amount added is less than 5 mass%, cutting edges of the starting material alumina remain and the cohesive force of the agglomerate becomes strong, whereas if it exceeds 300 mass%, excess aluminum hydroxide is mixed as a free fine particulate alumina in the product and this is not preferred.

As for the chemicals further added, in addition to ammonium chloride, a halogen compound other than ammonium chloride and a boron compound, which are known as the crystal growth accelerator for alumina, are used. The halogen compound other than ammonium chloride is a fluorine compound such as AlF₃, NaF, CaF₂, MgF₂ and Na₃AlF₆, or a boron-fluorine compound such as ammonium borofluoride, potassium borofluoride and sodium borofluoride. Examples of the boron compound include B₂O₃, H₃BO₃ and mNa₂O·nB₂O₃. In particular, a combination use of a fluorine compound and a boron compound is preferred.

The amount of each chemical added varies depending on the purity of the alumina as starting material, the heating temperature, the residence time in furnace and the kind of heating furnace and therefore cannot be flatly defined, but, the effective concentration of ammonium chloride added is from 2 to 8 mass%, preferably from 4 to 6 mass%, based on the entire alumina content. The ammonium chloride has a function of more effectively and uniformly causing a reaction for the acceleration of rounding and if the amount added thereof is less than 2 mass%, the effect of accelerating the rounding decreases, whereas if it exceeds 8 mass%, an effect attributable to increase in the amount added is not obtained but rather the uniformity is lost. The amount added of the crystal growth accelerator other than ammonium chloride, such as fluorine compound and boron compound (in the case where these two compounds are used in combination, the total amount), is from 1 to 7 mass%, preferably from 3 to 5 mass%, based on the entire alumina content. If the amount added of the crystal growth accelerator such as fluorine compound is less than 1 mass%, the effect on the acceleration of crystallization is not obtained, whereas if it exceeds 7 mass%, the acceleration of crystallization is increased only locally, causing large variations in crystallization.

The composition containing these alumina, alumina hydrate, ammonium chloride and crystal growth accelerator is mixed and then heated. At this time, from the standpoint of enhancing the reaction rate, the mixture is preferably granulated before heating.

The mixing method is not particularly limited and may be sufficient if respective components can be uniformly mixed, and a method commonly known as a powder mixing method can be used. Examples of the method include mixing devices such as rocking blender, Nauter mixer, ribbon mixer, V-shaped blander and Henschel mixer. Other than these, a grinder such as ball mill and vibrating mill can also be used.

With respect to the kind of the heating furnace for heat-treating (calcining) the mixed composition, a known furnace such as single furnace, tunnel furnace and rotary kiln may be used and the heating temperature is not particularly limited as long as the final product can be α-alumina. The heating temperature is 1,000°C to 1,600°C, preferably from 1,350 to 1,600°C, more preferably from 1,400 to 1,550°C. If the heating temperature exceeds 1,600°C, the cohesive force of the agglomerate is increased even in the co-presence of aluminum hydroxide and the agglomerate cannot be easily disintegrated into primary particles.

The residence time in the heating furnace varies depending on the heating temperature, but a residence time of 30 minutes or more, preferably on the order of 1 to 3 hours, is necessary.

The particulate alumina prepared by such a method takes the form of a secondary agglomerated particle in many cases and therefore, is disintegrated in a short time by a known grinding device such as ball mill, vibrating mill and jet mill, whereby a rounded particulate alumina having a desired particle size distribution, preferably having an average particle size (primary particle) of 10 µm or less, more preferably from 0.3 to 8 µm, can be obtained.

In the above-described production method, when alumina or aluminum hydroxide reduced in the radioactive element such as uranium or thorium is used, a rounded particulate alumina having a low α-ray radiant quantity can be produced. In use as a filler for resin sealing of a high-integrated IC or the like, the rounded particulate alumina having a low α-ray radiant quantity (0.01 c/cm²·hr) is useful so as to prevent the memory device from erroneous operations (e.g., software error) by α-ray.

The particulate alumina of the present invention is preferably filled in an oil or a polymer compound such as rubber and plastic, and can be suitably used as a highly thermally conductive grease composition, a highly thermally conductive rubber composition or a highly thermally conductive plastic composition. In particular, the filling is preferably performed to give a particulate alumina content of 70 mass% or more.

The polymer compound constituting the composition of the present invention may be a known polymer compound, but preferred examples thereof include an aliphatic resin, an unsaturated polyester resin, an acrylic resin, a methacrylic resin, a vinyl ester resin, an epoxy resin and a silicone resin.

These resins each may be a low molecular weight polymer or a high molecular weight polymer or may be in the form of oil, rubber or cured product and this may be arbitrarily selected according to the purpose for which the resin is used and the environment.

Examples of the resin include a hydrocarbon-based resin (e.g., polyethylene, ethylene-vinyl acetate copolymer, ethylene-acrylate copolymer, ethylene-propylene copolymer, poly(ethylene-propylene), polypropylene, polyisoprene, poly(isoprene-butylene), polybutadiene, poly(styrene-butadiene), poly(butadiene-acrylonitrile), polychloroprene, chlorinated polypropylene, polybutene, polyisobutylene, olefin resin, petroleum resin, styrol resin, ABS resin, chroman·indene resin, terpene resin, rosin resin, diene resin); a (meth)acrylic resin (for example, a resin obtained by homopolymerizing a monomer such as methyl (meth)acrylate, ethyl (meth)acrylate, 2-ethylhexyl (meth)acrylate, n-nonyl (meth)acrylate, (meth)acrylic acid and glycidyl (meth)acrylate, a resin obtained by copolymerizing a plurality of these monomers, polyacrylonitrile and a copolymer thereof, polycyanoacrylate, polyacrylamide, and poly(meth)acrylate); a vinyl acetate- or vinyl alcohol-based resin (e.g., vinyl acetate resin, polyvinyl alcohol, polyvinyl acetal-based resin, polyvinyl ether);
a halogen-containing resin (e.g., vinyl chloride resin, vinylidene chloride resin, fluorine-based resin); a nitrogen-containing vinyl resin (e.g., polyvinylcarbazole, polyvinylpyrrolidone, polyvinylpyridine, polyvinylimidazole); a diene-based polymerization product (e.g., butadiene-based synthetic rubber, chloroprene-based synthetic rubber, isoprene-based synthetic rubber); polyethers (e.g., polyethylene glycol, polypropylene glycol, hydrin rubber, Penton resin); a resin of polyethylene-imines; a phenol-based resin (e.g., phenol·formalin resin, cresol·formalin resin, modified phenol resin, phenol·furfural resin, resorcin resin); an amino resin (e.g., urea resin, modified urea resin, melamine resin, guanamine resin, aniline resin, sulfonamide resin); an aromatic hydrocarbon-based resin (e.g., xyleneformaldehyde resin, toluene·formalin resin); a ketone resin (e.g., cyclohexanone resin, methyl ethyl ketone resin); a saturated alkyd resin; an unsaturated polyester resin (e.g., maleic anhydride-ethylene glycol polycondensate, maleic anhydride-phthalic anhydride-ethylene glycol polycondensate); an allyl phthalate resin (for example, a resin obtained by crosslinking an unsaturated polyester resin with diallyl phthalate); a vinyl ester resin (for example, a resin obtained by crosslinking a primary polymer having a highly reactive acryl double bond at the terminal and having a bisphenol A-type ether bond in the main chain, with styrene, acryl ester or the like); an allyl ester resin; polycarbonate; a polyphosphoric acid ester resin; a polyamide resin; a polyimide resin; a silicone resin (for example, a silicone oil such as polydimethylsiloxane, a silicone rubber, a silicone resin and a reactive silicone resin having in the molecule a hydrosiloxane, hydroxysiloxane, alkoxysiloxane or vinylsiloxane structure and being curable by a catalyst or heat); a furan resin; a polyurethane resin; a polyurethane rubber; an epoxy resin (for example, those using a condensate of bisphenol A with epichlorohydrin, a condensate of novolak-type phenolic resin with epichlorohydrin, or a condensate of a polyglycol with epichlorohydrin); a phenoxy-type resin; and modified products thereof. One of these may be used alone, or two or more of the resins may be used in combination.

These polymer materials each may have a low molecular weight or a high molecular weight or may be in the form of oil, rubber or cured product and this may be arbitrarily selected according to the purpose for which the material is used and the environment.

Among these, more preferred are an unsaturated polyester resin, an acrylic resin, a methacrylic resin, a vinyl ester resin, an epoxy resin and a silicone resin.

The polymer material is also preferably an oily substance. The grease obtained by mixing the particulate alumina and an oil not only follows the unevenness of a heating element and a heat radiator but also can narrow the space therebetween to more enhance the heat-radiating effect.

The oil which can be used is not particularly limited and a known oil can be used. Examples thereof include a silicone oil, a petroleum-based oil, a synthetic oil and a fluorine-based oil.

The particulate alumina of the present invention can be mixed with a ceramic raw material such as glass to prepare a composition and, if desired, subjected to shaping, calcining and the like.

The surface of the particulate alumina in the present invention is preferably coated with a surface-treating agent. For the surface-treating agent, a silane coupling agent, a compound having any one or more group selected from the group consisting of an amino group, a carboxyl group and an epoxy group, or a modified silicone oil is used.

When the surface-treated particulate alumina is kneaded with a resin, the content of the particulate alumina in the composition can be increased as compared with the case where a surface-untreated particulate alumina is kneaded with a resin. Furthermore, even when the amount of the particulate alumina contained in the composition is increased, increase in the viscosity of the kneaded product is relatively small and the flexibility of the composition is less lost, so that the composition can be enhanced in the machine resistance or the like.

The silane coupling agent may be sufficient if it has a hydrolyzable substituent such as halogen atom or alkoxy group on the silicon atom, and a known compound can be used. Preferred examples thereof include vinyltrichlorosilane, vinyltrimethoxysilane, β-(3,4-epoxycyclohexyl)ethyltrimethoxysilane, γ-glycidoxypropyltriethoxysilane, γ-methacryloxypropyltrimethoxysilane, γ-aminopropyltriethoxysilane, N-phenyl-γ-aminopropyltrimethoxysilane, γ-chloropropyltrimethoxysilane, γ-mercaptopropyltrimethoxysilane, n-hexyltrimethoxysilane, n-octyltrimethoxysilane, n-dodecyltrimethoxysilane, phenyltriethoxysilane, diphenyldimethoxysilane and hexamethyldisilazane. One of these may be used alone, or two or more of the compounds may be used in combination.

The compound having one or more group of an amino group, a carboxyl group and an epoxy group is preferably a compound capable of readily adsorbing or reacting on the surface of particulate alumina under the action of such a group, and a known compound can be used.

Preferred examples thereof include 1,2-epoxyhexane, 1,2-epoxydodecane, n-hexylamine, n-dodecylamine, p-n-hexylaniline, n-hexylcarboxylic acid, n-dodecylcarboxylic acid and p-n-hexylbenzoic acid.

As for the modified silicone oil, preferred examples thereof include KF-105, KF-101, KF-102, X-22-173DX, KF-393, KF-864, KF-8012, KF-857, X-22-3667, X-22-162A, X-22-3701E (all are produced by Shin-Etsu Chemical Co., Ltd.), TSF4700, TSF4701, TSF4702, TSF4703, TSF4730*, TSF4770, TSE3070 (all are produced by GE Toshiba Silicones Co., Ltd.), SF8417, BY16-828, BY16-849, BY16-892, BY16-853, BY16-837, SF8411, BY16-875, BY16-855, SF8421, SF8418 and BY16-874 (all produced by Toray Dow Corning Silicone). One of these may be used alone, or two or more of the modified silicone oils may be used in combination.

The method for coating such a compound on the particulate alumina is not particularly limited and a known method may be used. Examples thereof include a dry processing method and a wet processing method.

The coverage of the silane coupling agent or the like on the particulate alumina is preferably from 0.05 to 5 mass% based on the particulate alumina. If the coverage is less than 0.05 mass%, the coating effect is difficult to obtain, whereas if the coverage exceeds 5 mass%, the content of unreacted silane coupling agent or the like increases and this is disadvantageous, for example, in that such a compound remains unreacted as an impurity.

When the composition of the present invention is formed into a sheet or grease and inserted between the heat-generating portion of an electronic component or semiconductor device and the high thermally conductive component or plate, the heat generated can be efficiently dissipated and the electronic component or semiconductor device can be prevented from heat deterioration or the like and thereby reduced in failure rate or favored with a prolonged life. The electronic component or semiconductor device is not particularly limited, but specific examples thereof include CPU (central processing unit) of computers, PDP (plasma display), energy devices (for example, lead storage battery, secondary battery and capacitor) or peripheral equipment thereof (for example, in a hybrid electric vehicle, a device of providing the thermally conductive composition between the secondary battery and the heat radiator to control the temperature and thereby stabilize battery properties), a heat radiator of electric motors, a Peltier element, an inverter and a (high) power transistor super-luminosity LED. Also, the composition is used by filling it in a glass frit for the purpose of enhancing the strength of a ceramic substrate (LTCC (low-temperature co-fired ceramic substrate)) or the like.

### BRIEF DESCRIPTION OF THE DRAWINGS

Fig. 1 is a graph showing cumulative frequency distribution of the particulate alumina obtained in Example 1.
Fig. 2 is a scanning electron microphotograph of the alumina particle obtained in Example 1.

### BEST MODE FOR CARRYING OUT THE INVENTION

The present invention is described in greater detail below by referring to Examples and Comparative Examples.

### Example 1

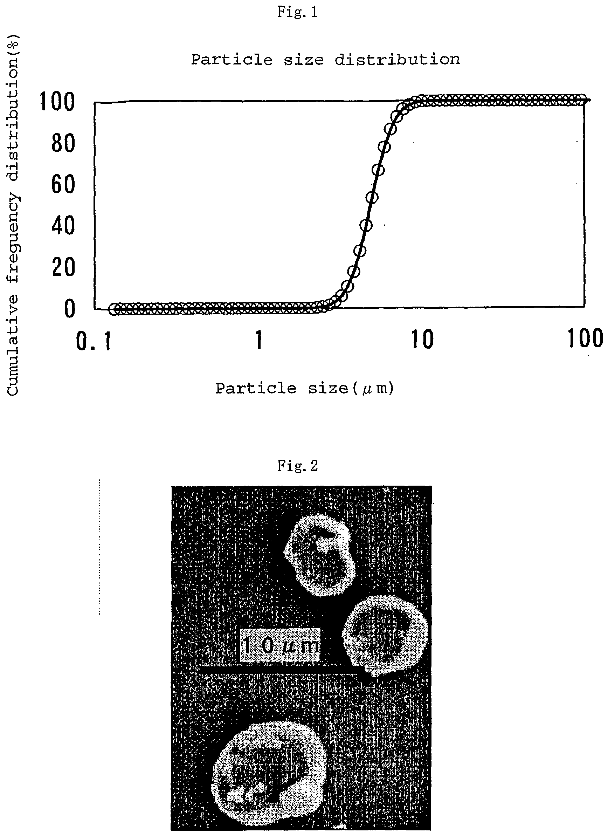

To 100 parts by mass of commercially available alumina (produced by Showa Denko K.K.; average particle size: 3.08 µm), 200 parts by mass of aluminum hydroxide (produced by Showa Denko K.K., average particle size: 1.1 µm), 5 parts by mass of ammonium chloride, 2 parts by mass of anhydrous aluminum fluoride and 2 parts by mass of boric acid were added and mixed. The mixture was charged in a calcination vessel and heat-treated at maximally 1,500°C for a residence time of 3 hours in a tunnel kiln. The heat-treated product was taken out from the calcination vessel and disintegrated by an air grinder. The particle size distribution of the disintegrated product was measured using sodium hexametaphosphate as a dispersant by laser diffraction particle size distribution measuring apparatus Microtac HRA Particle Size Analyzer manufactured by Nikkiso Co., Ltd. Fig. 1 shows the particle size distribution. Also, the shape of the particulate alumina was observed by a scanning electron microscope (SEM). Fig. 2 shows the SEM photograph.

In order to evaluate the filling property in rubbers or plastics, 400 parts by mass of the disintegrated product obtained after disintegration was blended with 100 parts by mass of silicone oil (a 1:1 blend of TSE3070(A) and TSE3070(B) produced by GE Toshiba Silicones Co., Ltd.), mixed and further mixed for 5 minutes by a centrifugal defoaming and mixing device at 750 rpm. The viscosity of the obtained composition at 25°C was measured as the silicone viscosity by a Brookfield-type viscometer.

Also, 250 parts of the alumina disintegrated product was blended with 100 parts by mass of epoxy resin and mixed by a chemistirrer while setting the rotation to High Speed 3 and after allowing the mixture to stand at 25°C for 2 hours, the viscosity was measured as the epoxy viscosity by a Brookfield-type viscometer. The evaluation results are shown in Table 1.

### Example 2

Evaluations were performed in the same manner as in Example 1 except for using a commercially available calcined alumina (produced by Showa Denko K.K., average particle size: 1.48 µm) as the alumina starting material.

### Example 3

Evaluations were performed in the same manner as in Example 1 except for using a commercially available calcined alumina (produced by Showa Denko K.K., average particle size: 5.24 µm) as the alumina starting material.

### Example 4 (reference example)

Evaluations were performed in the same manner as in Example 1 except for using the same alumina starting material as in Example 1 and adding thereto ammonium chloride and aluminum fluoride at a ratio shown in Table 1.

### Example 5 (reference example)

Evaluations were performed in the same manner as in Example 4 except for using boric acid in place of aluminum fluoride in Example 4.

### Comparative Example 1

Evaluations were performed in the same manner as in Example 1 except for not adding ammonium chloride.

### Comparative Example 2

Evaluations were performed in the same manner as in Example 1 except for not adding aluminum fluoride and boric acid.

### Comparative Example 3

Evaluations were performed in the same manner as in Example 1 except for not adding aluminum hydroxide.

**Table 1**

| | Example 1 | Example 2 | Example 3 | Example 4 | Example 5 | Comparative Example 1 | Comparative Example 2 | Comparative Example 3 |
|---|---|---|---|---|---|---|---|---|
| Alumina (parts by mass) | 100 | | | | | | | |
| Average particle size (µm) | 3.08 | 1.48 | 5.24 | 3.08 | 3.08 | 3.08 | 3.08 | 3.08 |
| | | | | | | | | |
| Aluminum hydroxide (parts by mass) | 200 | | | | | | | - |
| Average particle size (µm) | 1.1 | | | | | | | - |
| | | | | | | | | |
| Ammonium chloride (parts by mass) | 5 | 5 | 5 | 5 | 5 | - | 5 | 5 |
| Aluminum fluoride (parts by mass) | 2 | 2 | 2 | 4 | - | 2 | - | 2 |
| Boric acid (parts by mass) | 2 | 2 | 2 | - | 3 | 2 | - | 2 |
| | | | | | | | | |
| Baked·disintegrated product | | | | | | | | |
| Average particle size (µm) | 5.6 | 3.8 | 7.4 | 6.4 | 4.9 | 4.7 | 2.7 | 3.1 |
| | | | | | | | | |
| Epoxy viscosity (P) | 3,350 | 6,250 | 3,800 | 3,400 | 4,020 | 8,750 | 18,250 | 14,500 |
| Silicone viscosity (P) | 3,360 | 5,160 | 3,720 | 3,440 | 4,130 | 8,550 | 16,950 | 13,550 |
| | | | | | | | | |
| Particle shape | rounded particles | rounded particles | rounded particles | rounded particles | rounded particles | amorphous particles where a part of particles have cutting edges | particles not having rounded shape, where agglomerated particles are present | amorphous particles having cutting edges |

In table 1 examples 4 and 5 are reference examples.

### INDUSTRIAL APPLICABILITY

According to the production method of the present invention, a rounded particulate alumina of 10 µm or less can be industrially produced at a low cost. The rounded particulate alumina produced by the production method of the present invention shows excellent fluidity and when filled in resins such as rubber and plastic, can ensure reduced viscosity and high filling efficiency, so that this rounded particulate alumina can be expected to provide a compounded material having high thermal conductivity.

## Claims

1. A method for producing a particulate α-alumina having an average particle size of 10 µm or less, comprising heat-treating (calcining) a composition comprising alumina having an average particle size of 0.3 to 8 µm, an alumina hydrate having an average particle size of 10 µm or less in an amount of 5 to 300 mass% in terms of alumina, ammonium chloride in an amount of 2 to 8 mass% based on the entire alumina content, a fluorine compound or a boron-fluorine compound, and a boron compound in an amount of 1 to 7 mass% based on the entire alumina content at a heating temperature of 1,000°C or higher and 1,600°C or lower, and then disintegrating the heat-treated product.

2. The production method of a particulate alumina as claimed in claim 1, wherein the fluorine compound is at least one member selected from the group consisting of AlF₃, NaF, CaF₂, MgF₂ and Na₃AlF₆.

3. The production method of a particulate alumina as claimed in claim 1, wherein the boron compound is at least one member selected from the group consisting of B₂O₃, H₃BO₃, mNA₂O·nB₂O₃ (m and n each represents an integer of 1 or more, hereinafter the same) and a boron-fluorine compound.

4. The production method of a particulate alumina as claimed in any of claims 1 to 3, wherein the particulate alumina has a rounded shape having no cutting edge.

5. The production method of a particulate alumina as claimed in any one of claims 1 to 4, wherein the composition is previously granulated before heat-treating (calcining) the composition.

6. The production method of a particulate alumina as claimed in any one of claims 1 to 5, wherein the alumina hydrate is at least one member selected from the group consisting of an aluminum hydroxide, an alumina gel and a partially hydrated aluminum compound.

7. A resin composition comprising a particulate alumina produced by the production method as claimed in any one of claims 1 to 6, and a polymer compound.

8. The resin composition as claimed in claim 7, wherein the polymer compound is at least one member selected from an aliphatic resin, an unsaturated polyester resin, an acrylic resin, a methacrylic resin, a vinyl ester resin, an epoxy resin and a silicone resin.

9. The resin composition as claimed in claim 7 or 8, wherein the content of the particulate alumina is 70 mass% or more.

10. The resin composition as claimed in any one of claims 7 to 9, wherein the particulate alumina is coated with a surface-treating agent.

11. The resin composition as claimed in claim 10, wherein the surface-treating agent is a silane coupling agent.

12. The resin composition as claimed in claim 10, wherein the surface-treating agent is a compound having one or more group selected from the group consisting of an amino group, a carboxyl group and an epoxy group.

13. The resin composition as claimed in claim 10, wherein the surface-treating agent is a modified silicone oil.

14. The resin composition as claimed in any one of claims 10 to 13, wherein the coverage of the surface-treating agent is from 0.05 to 5 mass% based on the particulate alumina.

15. A ceramic composition comprising a particulate alumina produced by the production method as claimed in any one of claims 1 to 6.

16. An electronic component or semiconductor device comprising the resin composition as claimed in any one of claims 7 to 14.

17. A central processing unit (CPU) or plasma display (PDP) comprising the resin composition as claimed in any one of claims 7 to 14.

18. A peripheral equipment for batteries, or a peltier element, an inverter or a power transistor, comprising the resin composition as claimed in any one of claims 7 to 14.

## Patentansprüche

1. Verfahren zum Herstellen von teilchenförmigem α-Aluminiumoxid einer mittleren Teilchengröße von 10 µm oder weniger, welches das Hitzebehandeln (Kalzinieren) einer Zusammensetzung, die Aluminiumoxid einer mittleren Teilchengröße von 0,3 bis 8 µm, ein Aluminiumoxidhydrat einer mittleren Teilchengröße von 10 µm oder weniger in einer Menge von 5 bis 300 Massen-% in Bezug auf Aluminiumoxid, Ammoniumchlorid in einer Menge von 2 bis 8 Massen-% in Bezug auf den Gesamtaluminiumoxidgehalt, eine Fluorverbindung oder eine Borfluorverbindung sowie eine Borverbindung in einer Menge von 1 bis 7 Massen-% in Bezug auf den Gesamtaluminiumoxidgehalt enthält, bei einer Temperatur von 1000°C oder höher und 1600°C oder niedriger und das anschließende Zerkleinern des hitzebehandelten Produkts umfasst.

2. Verfahren zur Herstellung eines teilchenförmigen Aluminiumoxids nach Anspruch 1, wobei die Fluorverbindung mindestens ein Mitglied der Gruppe ist, die aus AlF₃, NaF, CaF₂, MgF₂ und Na₃AlF₆ besteht.

3. Verfahren zur Herstellung eines teilchenförmigen Aluminiumoxids nach Anspruch 1, wobei die Borverbindung mindestens ein Mitglied ist, das aus der Gruppe ausgewählt ist, die aus B₂O₃, H₃BO₃, mNA₂O·nB₂O₃ (m und n stellen jeweils eine ganze Zahl von 1 oder mehr dar und haben im Folgenden dieselbe Bedeutung) und einer Borfluorverbindung besteht.

4. Verfahren zur Herstellung eines teilchenförmigen Aluminiumoxids nach einem der Ansprüche 1 bis 3, wobei das teilchenförmige Aluminiumoxid eine runde Form ohne scharfe Kanten aufweist.

5. Verfahren zur Herstellung eines teilchenförmigen Aluminiumoxids nach einem der Ansprüche 1 bis 4, wobei die Zusammensetzung vor der Hitzebehandlung (Kalzinierung) der Zusammensetzung granuliert wird.

6. Verfahren zur Herstellung eines teilchenförmigen Aluminiumoxids nach einem der Ansprüche 1 bis 5, wobei das Aluminiumoxidhydrat mindestens ein Mitglied aus der Gruppe ist, die aus einem Aluminiumhydroxid, einem Aluminiumoxidgel und einer teilweise hydrierten Aluminiumverbindung besteht.

7. Harzzusammensetzung, die ein durch das Herstellungsverfahren nach einem der Ansprüche 1 bis 6 hergestelltes teilchenförmiges Aluminiumoxid und eine Polymerverbindung umfasst.

8. Harzzusammensetzung nach Anspruch 7, wobei die Polymerverbindung mindestens ein Mitglied aus der Gruppe ist, die aus einem aliphatischen Harz, einem ungesättigten Polyesterharz, einem Acrylharz, einem Methacrylharz, einem Vinylesterharz, einem Epoxyharz und einem Silikonharz besteht.

9. Harzzusammensetzung nach Anspruch 7 oder 8, wobei der Gehalt des teilchenförmigen Aluminiumoxids 70 Massen-% oder höher ist.

10. Harzzusammensetzung nach einem der Ansprüche 7 bis 9, wobei das teilchenförmige Aluminiumoxid mit einem Oberflächenbehandlungsmittel beschichtet ist.

11. Harzzusammensetzung nach Anspruch 10, wobei das Oberflächenbehandlungsmittel ein Silankopplungsmittel ist.

12. Harzzusammensetzung nach Anspruch 10, wobei das Oberflächenbehandlungsmittel eine Verbindung mit mindestens einer Gruppe ist, die aus der Gruppe ausgewählt ist, die aus einer Amingruppe, einer Carboxygruppe und einer Epoxygruppe besteht.

13. Harzzusammensetzung nach Anspruch 10, wobei das Oberflächenbehandlungsmittel ein modifiziertes Silikonöl ist.

14. Harzzusammensetzung nach einem der Ansprüche 10 bis 13, wobei der Grad der Abdeckung mit dem Oberflächenbehandlungsmittel 0,05 bis 5 Massen-% in Bezug auf das teilchenförmige Aluminiumoxid ist.

15. Keramische Zusammensetzung, die ein nach dem Verfahren nach einem der Ansprüche 1 bis 6 erhaltenes teilchenförmiges Aluminiumoxid enthält.

16. Elektronische Komponente oder Halbleitervorrichtung, welche die Harzzusammensetzung nach einem der Ansprüche 7 bis 14 enthält.

17. Zentralprozessierungseinheit (CPU) oder Plasmaanzeige (PDP), welche die Harzzusammensetzung nach einem der Ansprüche 7 bis 14 enthält.

18. Periphere Ausrüstung für Batterien oder ein Peltierelement, ein Inverter oder ein Stromtransistor, der die Harzzusammensetzung nach einem der Ansprüche 7 bis 14 enthält.

## Revendications

1. Procédé de production d'une α-alumine particulaire ayant une taille moyenne des particules inférieure ou égale à 10 µm, comprenant le traitement thermique (calcination) d'une composition comprenant une alumine ayant une taille moyenne des particules de 0,3 à 8 µm, une alumine hydratée ayant une taille moyenne des particules inférieure ou égale à 10 µm en une quantité de 5 à 300 % en masse en termes d'alumine, du chlorure d'ammonium en une quantité de 2 à 8 % en masse sur la base de la teneur totale en alumine, un composé fluoré ou un composé borofluoré, et un composé boré en une quantité de 1 à 7 % en masse sur la base de la teneur totale en alumine à une température de chauffage supérieure ou égale à 1 000 °C et inférieure ou égale à 1 600 °C, puis la désintégration du produit traité thermiquement.

2. Procédé de production d'une alumine particulaire selon la revendication 1, dans lequel le composé fluoré est au moins un élément choisi dans le groupe constitué de l'AlF₃, du NaF, du CaF₂, du MgF₂ et du Na₃AlF₆.

3. Procédé de production d'une alumine particulaire selon la revendication 1, dans lequel le composé boré est au moins un élément choisi dans le groupe constitué du B₂O₃, du H₃BO₃, du mNA₂O•nB₂O₃ (m et n représentent chacun un nombre entier supérieur ou égal à 1, de même ci-dessous) et un composé borofluoré.

4. Procédé de production d'une alumine particulaire selon l'une quelconque des revendications 1 à 3, dans lequel l'alumine particulaire a une forme arrondie sans aucun bord tranchant.

5. Procédé de production d'une alumine particulaire selon l'une quelconque des revendications 1 à 4, dans lequel la composition est préalablement granulée avant le traitement thermique (calcination) de la composition.

6. Procédé de production d'une alumine particulaire selon l'une quelconque des revendications 1 à 5, dans lequel l'alumine hydratée est au moins un élément choisi dans le groupe constitué d'un hydroxyde d'aluminium, d'un gel d'alumine et d'un composé à base d'aluminium partiellement hydraté.

7. Composition de résine comprenant une alumine particulaire produite par le procédé de production selon l'une quelconque des revendications 1 à 6, et un composé polymère.

8. Composition de résine selon la revendication 7, dans laquelle le composé polymère est au moins un élément choisi parmi une résine aliphatique, une résine de polyester insaturée, une résine acrylique, une résine méthacrylique, une résine de vinylester, une résine époxy et une résine de silicone.

9. Composition de résine selon la revendication 7 ou 8, dans laquelle la teneur de l'alumine particulaire est supérieure ou égale à 70 % en masse.

10. Composition de résine selon l'une quelconque des revendications 7 à 9, dans laquelle l'alumine particulaire est revêtue d'un agent de traitement de surface.

11. Composition de résine selon la revendication 10, dans laquelle l'agent de traitement de surface est un agent de couplage de silane.

12. Composition de résine selon la revendication 10, dans laquelle l'agent de traitement de surface est un composé comportant un ou plusieurs groupes choisis dans le groupe constitué d'un groupe amino, d'un groupe carboxyle et d'un groupe époxy.

13. Composition de résine selon la revendication 10, dans laquelle l'agent de traitement de surface est une huile de silicone modifiée.

14. Composition de résine selon l'une quelconque des revendications 10 à 13, dans laquelle le pouvoir couvrant de l'agent de traitement de surface est de 0,05 à 5 % en masse sur la base de l'alumine particulaire.

15. Composition de céramique comprenant une alumine particulaire produite par le procédé de production selon l'une quelconque des revendications 1 à 6.

16. Composant électronique ou dispositif semiconducteur comprenant la composition de résine selon l'une quelconque des revendications 7 à 14.

17. Unité centrale (CPU) ou écran à plasma (PDP) comprenant la composition de résine selon l'une quelconque des revendications 7 à 14.

18. Équipement périphérique pour batteries, ou élément Peltier, onduleur ou transistor de puissance, comprenant la composition de résine selon l'une quelconque des revendications 7 à 14.
